# EUROPÄISCHE PATENTSCHRIFT

(11) **EP 3 491 406 B1**
(45) Veröffentlichungstag und Bekanntmachung des Hinweises auf die Patenterteilung: **07.06.2023**
(21) Anmeldenummer: 17739976.3
(22) Anmeldetag: 14.07.2017
(51) Int. Cl.: G01R 31/28, G01R 31/70

(54) **TESTSYSTEM ZUR ÜBERPRÜFUNG VON ELEKTRONISCHEN VERBINDUNGEN**
TEST SYSTEM FOR TESTING ELECTRONIC CONNECTIONS
SYSTÈME DE TEST DESTINÉ À CONTRÔLER DES CONNEXIONS ÉLECTRIQUES

(30) Priorität: 01.08.2016 DE 102016114146
(43) Veröffentlichungstag der Anmeldung: 05.06.2019
(73) Patentinhaber: Endress+Hauser Flowtec AG, 4153 Reinach (CH)
(72) Erfinder: BÖHLER, Thomas, 79400 Kandern (DE); BRUDERMANN, Matthias, 4313 Moehlin (CH); WERLE, Christoph, 4410 Liestal (CH); WUCHER, Markus, 79541 Lörrach (DE); KOLLMER, Daniel, 79689 Maulburg (DE); ADAM, Ludovic, F-68490 Chalampé (FR)
(74) Vertreter: Penner, Paul
(86) Internationale Anmeldenummer: PCT/EP2017/067814
(87) Internationale Veröffentlichungsnummer: WO 2018/024465

(56) Entgegenhaltungen:
- DE-A1-102004 063 488
- US-A1- 2010 259 289
- US-A1- 2014 062 521
- US-A1- 2014 263 613
- US-A1- 2015 168 452

## Beschreibung

Die vorliegende Erfindung betrifft ein Testsystem nach dem Oberbegriff des Anspruchs 1.

Die EP 0 633 478 A2 offenbart ein Testsystem zur Überprüfung von elektronischen Verbindungen von elektronischen Baugruppen mit einer zu überprüfenden Leiterplatte. Weitere Testsysteme finden sich in den Dokumenten US2014/062521 und US2010/259289.

Derartige Testsysteme wurden sukzessive weiterentwickelt. So sind die Elektroden durch Gelenke und/oder Roboterarme an die Leiterplatte heranführbar und ermitteln z.B. durch Widerstandsmessung, ob eine Lötverbindung richtig positioniert ist und eine elektrische Kontaktierung der elektronischen Baugruppen der Leiterplatte über diese Lötverbindung erfolgen kann.

Der Test der elektrischen Kontaktierung erfolgt durch Widerstandsmessung. Aufgrund von Fehlpositionierung, aufgrund fehlerhafter Bestückung oder anderen Gründen kann es zu einer übermäßigen Wärmeentwicklung auf der Oberfläche der Leiterplatte kommen.

Eine Überprüfung dieser Wärmeentwicklung ist in bestehenden Testsystemen mit Widerstandsmessung nicht vorgesehen.

Ausgehend vom bisherigen Stand der Technik ist es nunmehr Aufgabe der vorliegenden Erfindung ein gattungsgemäßes Testsystem in kompakter Bauweise um weitere Funktionen zu erweitern.

Die vorliegende Erfindung löst diese Aufgabe durch ein Testsystem mit den Merkmalen des Anspruchs 1.

Vorteilhafte Ausgestaltungen der Erfindung sind Gegenstand der Unteransprüche.

Die Temperaturmesseinrichtung ist vorteilhaft beweglich in die zumindest zwei Raumrichtungen, vorzugsweise in drei Raumrichtungen, innerhalb eines Gehäuses des Testsystems angeordnet. Dadurch kann die zu prüfende Leiterplatte bereichsweise durch die Temperaturmesseinrichtung analysiert werden, was eine genauere Ermittlung ermöglicht. Für eine zeiteffiziente Messung bei geringer Gefahr von Schädigungen der zu prüfenden Leiterplatte und des Testsystems ist es von Vorteil, wenn durch die Temperaturmesseinrichtung eine berührungslose Temperatur-Messung erfolgt.

Besonders bevorzugt kann die Temperaturmessung durch ein Thermographiesystem, insbesondere durch eine Infrarot-Kamera, erfolgen.

Das Testsystem weist zudem eine Kommunikationsschnittstelle mit zumindest drei elektrisch-leitenden Kontaktspitzen auf, welche durch Kontaktierung mit einer Kontaktierungsanordnung auf der Leiterplatte mit mehreren, insbesondere metallischen, Kontaktierungsstellen bzw. - bereichen einen Datenaustausch mit dem Datenspeicher der zu überprüfenden Leiterplatte ermöglichen, wobei der Datenaustausch nach einem Kommunikationsprotokoll erfolgt.

Über zumindest zwei der Kontaktspitzen kann vorteilhaft eine differenzielle Datenzuführung zur zu prüfenden Leiterplatte erfolgen und über zumindest zwei weitere Kontaktspitzen kann eine differenzielle Datenrückführung zur Leiterplatte erfolgen.

Die Kommunikationsschnittstelle und die Temperaturmesseinrichtung ist fest mit einem Testmodul, beispielsweise einer Leiterplatte des Testmoduls, verbunden, wobei das Testmodul beweglich in mindesten zwei Raumrichtungen im Gehäuse des Testsystems angeordnet ist. Zusätzlich kann die Temperaturmesseinrichtung vorteilhaft in zumindest einer Raumrichtung gegenüber dem Testmodul beweglich angeordnet werden, so dass die Temperaturmesseinrichtung, z.B. für eine besonders genaue Messung, vom Testmodul zur zu prüfenden Leiterplatte hin verfahren werden kann.

Das Testsystem kann vorteilhaft einen Datenspeicher aufweisen, auf welchem Datensätze hinsichtlich zumindest einer zulässigen Wärmeskalierung einzelner Bauteile und/oder Teilbereiche einer Leiterplatte für einen Vergleich mit den ermittelten Temperatur- und/oder Wärmewerten der Bauteile der Leiterplatte hinterlegt sind.

Es ist von Vorteil, wenn die Prüfplatine eine Sensorvorrichtung, insbesondere eine Kamera oder einen Barcodescanner, zur Erkennung eines Erkennungsmerkmals der zu prüfenden Leiterplatte, insbesondere eines Barcodes oder Seriennummer oder QR-Code, aufweist wobei das Testsystem anhand des Erkennungsmerkmals einen Datensatz bezüglich eines zulässigen Temperaturprofils für diesen Leiterplattentyp aufruft.

Weiterhin kann das Testsystem eine Strom- und/oder Spannungsquelle, ggf. auch mit Regelcharakteristik, zur Energieversorgung der Temperaturmesseinrichtung aufweisen, wobei die Strom- und/oder Spannungsquelle fest verbunden mit der Temperaturmesseinrichtung und beweglich in mindestens zwei Raumrichtungen innerhalb des Gehäuses des Testsystems angeordnet ist.

Das Testsystem, insbesondere die Prüfplatine, kann zumindest ein Werkzeugbauteil aufweisen zur Reparatur von elektrischen Verbindungen an oder auf der Leiterplatte, wobei das Werkzeugbauteil anhand von mittels Temperaturmesseinrichtung ermittelte Messwerte gesteuert wird. Somit kann ein erkannter Defekt direkt vor Ort behoben werden.

Das Testmodul kann ein Transformermodul mit einem Übertrager aufweisen, mit dem eine galvanische Trennung zum Kommunikationsmodul auf der zu prüfenden Leiterplatte realisiert wird und eine Anpassung im Sinne einer Ethernet Verbindung sicherstellt insbesondere unabhängig davon, ob mit dem Kommunikationsmodul eine weitere elektrische Verbindung zu einer Ethernet Buchse besteht oder nicht.

Nachfolgend wird die Erfindung anhand mehrerer Ausführungsbeispiele und unter Zuhilfenahme der beiliegenden Figuren näher erläutert. Es zeigen:
Fig. 1 schematische Darstellung bezüglich eines erfindungsgemäßen achsengesteuerten Testsystems zur Prüfung von elektronischen Leiterplatten;
Fig. 2 schematische Darstellung eines Testmoduls als Teil des erfindungsgemäßen Testsystems;
Fig. 3 schematische Darstellung einer Produktionsstrecke zur Herstellung einer Leiterplatte mit einem in der Produktionsstrecke integrierten erfindungsgemäßen Testsystem 1;
Fig. 4 schematische Darstellung einer ersten Variante einer Kommunikationsschnittstelle als Teil des erfindungsgemäßen Testsystems;
Fig. 5 schematische Darstellung einer zweiten Variante einer Kommunikationsschnittstelle als Teil des erfindungsgemäßen Testsystems;
Fig. 6a schematische Darstellung einer Kontaktierungs-Anordnung einer Leiterplatte zum Datenaustausch mit einer Kommunikationsschnittstelle eines Testsystems;
Fig. 6b schematische Darstellung einer Haltevorrichtung zum Aus- und Einfahren von Kontaktspitzen der Kommunikationsschnittstelle;
Fig. 7 schematische Darstellung einer zweiten Kontaktierungs-Anordnung auf einer Leiterplatte zum Datenaustausch mit einer Kommunikationsschnittstelle eines Testsystems;
Fig. 8 schematische Unteransicht der zweiten Variante einer Kommunikationsschnittstelle des erfindungsgemäßen Testsystems, gemäß Fig. 5;
Fig. 9 Schaltplan einer Anordnung mehrerer Bauteile eines Testmoduls mit Kommunikationsschnittstelle des erfindungsgemäßen Testsystems;
Fig. 10 schematische Darstellung eines Schaltbildes einer LDO-Spannungsquelle mit dem Testmodul;
Fig. 11 schematische Darstellung eines Transformermoduls für eine Ethernet Kommunikation;
Fig. 12 schematische Darstellung einer rotierenden Kommunikationsschnittstelle;
Fig. 13 schematische Darstellung einer Realisierung mit unterschiedlichen Kommunikationsprotokolle.

Testsysteme zur Prüfung von elektronischen Leiterplatten sind an sich bekannt. Sie dienen der Prüfung der Funktionsweise einzelner Elektronik-Bauteile, welche auf der Leiterplatte angeordnet und mit dieser verlötet sind. Weiterhin dient ein entsprechendes Testsystem der Prüfung der elektrischen Verbindungen der Elektronikbauteile bzw. der Elektronickomponenten untereinander und mit den Leiterbahnen der Leiterplatte.

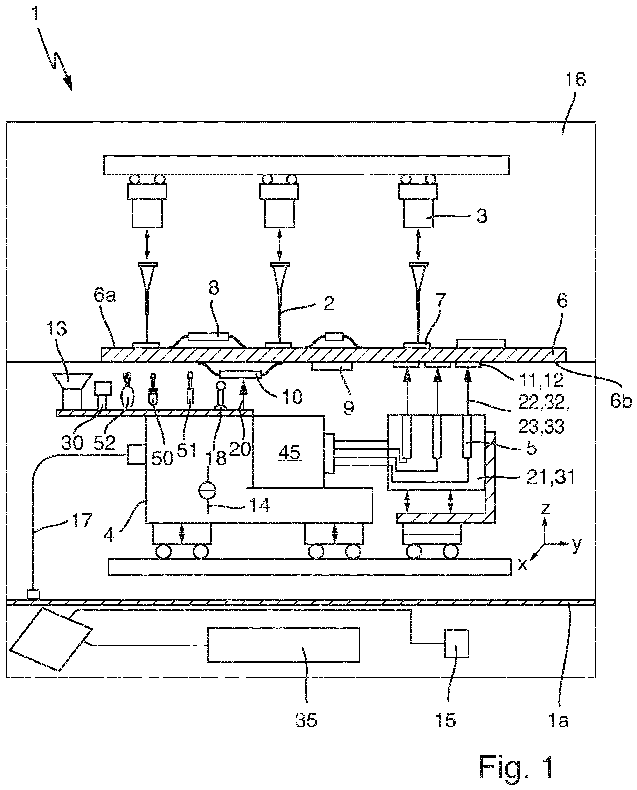

Figur 1 zeigt ein erfindungsgemäßes Testsystem 1 zum Testen von elektronischen Leiterplatten, wobei eine jeweilige zu prüfende Leiterplatte 6 eine Anzahl von integrierten Schaltungen 8 auf der Oberseite 6a der Leiterplatte 6 aufweist.

Oberhalb der zu prüfenden Leiterplatte werden durch das Testsystem 1 zumindest eine stiftartige Prüfspitze 2, vorzugsweise mehrere stiftartige Prüfspitzen 2, herangeführt. Diese Prüfspitzen können vorzugsweise als Elektroden ausgebildet sein. Das Heranführen der Prüfspitze oder Prüfspitzen kann beispielsweise durch Roboterarme 3 erfolgen, die oberhalb der zu prüfenden Leiterplatte 6 frei in x-, y- und z-Ebene, z.B. durch verfahrbare Teleskoparme oder durch x-, y- und z- linearmotorisierte Gelenkarme, beweglich zu Kontaktpunkten 7 der Leiterplatte hin- oder weggeführt werden. An diesen Kontaktpunkten 7 können Widerstandswerte ermittelt werden.

Die Roboterarme 3 können beispielsweise als lineargeführte Schlitten ausgebildet sein welcher eines oder mehrere Gelenke aufweist, so dass die stiftartigen Prüfspitzen 2 an die Leiterplatte von oben oder von mehreren Achsen heranführbar sind.

Unterhalb der zu prüfenden Leiterplatte 6 ist ein Testmodul 4 angeordnet, welche Teil des Testsystems 1 ist und zu einer Unterseite 6b der Leiterplatte 6 hin verfahrbar ist. Das Testmodul 4 ist somit analog verfahrbar in x-, y- und z-Richtung beweglich gegenüber der Leiterplatte 6 angeordnet. Dies wird z.B. in x und y-Richtung durch Linearführung, z.B. durch lineargeführte Gleitschienen bzw. sogenannte Lineartische, ermöglicht. Dies kann insbesondere durch eine Rollen-, Ketten- oder Seilzugführung erfolgen. Diese x- und y - Linearführung ist sodann in z-Richtung also senkrecht zur Platinenebene der Leiterplatte 6 durch einen Roboterarm oder einen weitere Linearführung bewegbar.

Alternativ dazu kann auch die Leiterplatte 6 beweglich gegenüber dem Testmodul 4 und/oder der stiftartigen Prüfspitzen 2 angeordnet sein. In diesem Fall weist das Testsystem 1 eine Halterung auf, welche zumindest in x- und in y-Richtung, ggf. auch in z-Richtung beweglich, z.B. durch einen höhenverstellbaren Lineartisch, beweglich gelagert ist.

Das Testmodul 4 kann somit von unten an die Leiterplatte 6 herangeführt werden. Anders als die von oben herangeführten einzelnen Prüfnadeln, welche die elektrische Anbindung der Elektronikbauteile mit der Leiterplatte 6 prüfen, übernimmt das Testmodul eine Prüfung des Funktionstests, z.B. die Datenübertragung eines Kommunikationsmoduls 9 der Leiterplatte 6.

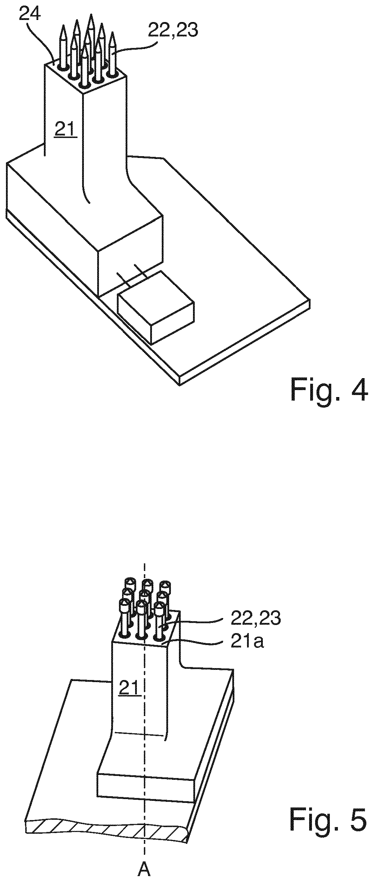

Das Testmodul 4 weist eine Kommunikationsschnittstelle 5 auf, zur Kommunikation mit dem Kommunikationsmodul 9 der zu prüfenden Leiterplatte 6. Mittels der Kommunikationsschnittstelle 5 kann durch das Testsystem 1 eine Programmierung eines auf der zu prüfenden Leiterplatte 6 angeordneten Datenspeichers 10 erfolgen. Das Testsystem kann auf diese Weise Daten auf den Datenspeicher beispielsweise eine Seriennummer, eine IP/Mac-Adresse, sowie werksseitig vorgegebene Abgleich-Einzelwerte und/oder Datensätze hinterlegen. Zwei bevorzugte Varianten einer Kommunikationsschnittstelle 5 sind in Fig. 4 und in Fig. 5 dargestellt.

Die Kommunikationsschnittstelle 5 weist in Fig. 4 vorzugsweise einen Gehäuseabschnitt 21 und mehrere Kontaktspitzen 22 auf, die in Form einer Array-Anordnung 23 aus einer Stirnfläche 24 des Gehäuseabschnitts 21 hervorstehen. Die Kontaktspitzen 22 der Array-Anordnung 23 sind in einer rechteckigen Anordnung mit insgesamt neun Kontaktspitzen angeordnet. Der Gehäuseabschnitt 21 setzt auf einer Platine auf, welche das Testmodul 4 sein kann oder eine vom Testmodul 4 abgesetzte Platine, welche jedoch über Datenleitungen sowie Energieversorgungsleitungen und vorzugsweise auch über eine feste mechanische Verbindung mit dem Testmodul 4 verbunden ist.

Dadurch die Energieversorgung und die Datenleitung der Kommunikationsschnittstelle in einer bevorzugten Variante der Erfindung direkt durch das Testmodul 4 und den darauf angeordneten oder damit verbundenen Bauteilen erfolgt, werden lange Datenübertragungswege vermieden und die Signalqualität beim Datentransfer als auch die Übertragungsgeschwindigkeit kann erhöht werden.

Die Array-Anordnung 23 dient der Kontaktierung des Kommunikationsmoduls 9 auf der zu prüfenden Leiterplatte. Dabei weist die Leiterplatte 9 metallische Kontaktierungsbereiche 11 auf. Die Kontaktierungsbereiche 11 sind punktförmige oder rechteckige Segmente, welche voneinander beabstandet sind und die gleiche Anordnung wie die Kontaktspitzen 22 der Array-Anordnung 23 aufweisen.

Die Kontaktspitzen 22 sind im Gehäuseabschnitt federgelagert, so dass sie bei Kontaktierung mit den Kontaktierungsbereichen 11 der Leiterplatte 6 zu einem Teil in den Gehäuseabschnitt 21 einfahren. Durch die Nachgiebigkeit bzw. die Ein- und Ausfahrbarkeit der Kontaktspitzen 22 in den Gehäuseabschnitt kann ein Verbiegen der Kontaktspitzen 22 und eine Schädigung der Kontaktierungsbereiche 11 der Leiterplatte 6 verhindert werden. Die Kontaktspitzen 22 können über zumindest ein Feststellelement in einer Einfahrposition gehalten werden, in welcher eine Feder, mit welcher die federgelagerte Kontaktspitze 22 zusammenwirkt, zusammengedrückt und folglich gespannt ist. So ist es möglich die Arrayanordnung, also die Anzahl an vollausgefahrenen Kontaktspitzen, zu verändern und somit an die Anzahl der Kontaktierungsbereiche 11 der Leiterplatte anzupassen. Sofern mehr Kontaktspitzen 22 als korrespondierende Kontaktierungsbereiche 11 zur Verfügung stehen, so würden starrhervorstehende, also nicht-federnd gelagerte Kontaktspitzen auf einer ungeschützten Oberfläche der Leiterplatte aufliegen, wodurch es zu einer Schädigung sowohl zur Schädigung der Kontaktspitzen 22 als auch zu einem Zerkratzen der Leiterplatte kommen kann. Dies wird durch die feststellbare Ein- und Ausfahrbarkeit einzelner Kontaktspitzen 22 aus oder in den Gehäuseabschnitt 21 vorteilhaft verhindert.

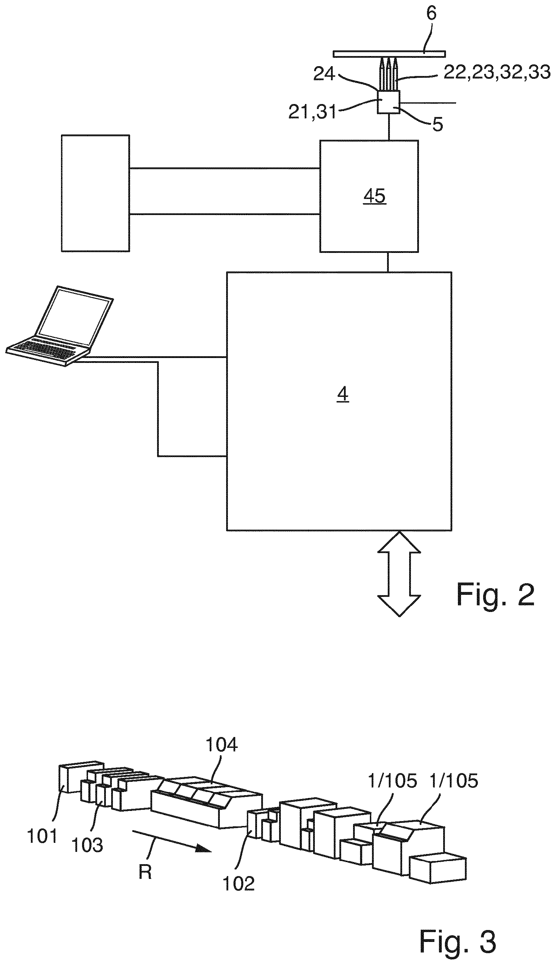

Fig. 2 zeigt schematisiert ein vorgenanntes Testmodul 4 in Verbindung mit der Kommunikationsschnittstelle 5. Dieses Testmodul 4 wird vorzugsweise zur Kommunikation vom Testsystem 1 beispielsweise in Verbindung mit einem Computer mit zur prüfenden Leiterplatte 6 eingesetzt. Zusätzlich kann es aber auch nützlich sein, über das Kommunikationsmodul 5 Messdaten von der zu prüfenden Leiterplatte abzugreifen und an die Messelektronik des Testsystems weiterzuleiten. Dies geschieht über Umschaltkontakte auf dem Testmodul 4.

Diese Umschaltkontakte ermöglichen den Einsatz des Testmoduls 4 zur Kommunikation, zur Weiterleitung der Messdaten oder ein gemischter Betrieb.

Über das Transformermodul 45, welches unter anderem auch Umschaltkontakte besitzt, können noch zusätzliche Datenquellen über das Kommunikationsmodul 5 direkt mit der zu prüfenden Leiterplatte 6 verbunden werden. Kontrollsignale, die vorzugsweise aus dem Testsystem 1 kommen, steuern beispielsweise die Umschaltung von Relais auf dem Transformermodul 45.

Die Kommunikationsschnittstelle 5 der Fig. 5 weist vorzugsweise ebenfalls einen Gehäuseabschnitt 31 und mehrere Kontaktspitzen 32 die in einer Array-Anordnung 33 an. In der Mitte ist ein Zapfen 34 angeordnet, welcher federgelagert ist und bei Kontakt mit der Leiterplatte um einen vorbestimmten Abstand in den Gehäuseabschnitt 31 einsinkt. Dadurch wird verhindert, dass eine Schädigung der Leiterplatte 6 oder eine Schädigung der Kontaktspitzen beim Aufsetzen der Array-Anordnung 33 auf der Leiterplatte 6.

Ein Array-Anordnung 23 oder 33 wird im Rahmen der Erfindung eine Anordnung aus mehreren Kontaktspitzen 22 oder 32 bezeichnet, welche in einem feststehenden und definierten Abstand zueinander auf einer Leiterplatte 6 aufsetzen und einen Datenaustausch an Kontaktpunkten vornehmen.

Dabei werden im einfachsten Fall drei Kontaktspitzen eingesetzt. Hiermit kann bereits eine Datenübertragung ermöglicht werden nach dem sogenannten SPI-Bussystem (Serial Peripheral Interface). Dabei wird eine erste Kontaktspitze 22 oder 32 benötigt zur Datenhinführung, eine zweite Kontaktspitze 22 oder 32 zur Datenrückführung und eine dritte Kontaktspitze 22 oder 32 für ein Referenzpotential.

Durch Ergänzen weiterer Kontaktspitzen können weitere Funktionalitäten ergänzt werden. So kann ein weiteres Referenzpotential abgegriffen werden. Es kann auch eine galvanische Trennung ermöglicht werden. Es kann eine Spannungsversorgung der Leiterplatte mit einer oder mehreren Spannungen erfolgen. Es kann weiterhin eine oder mehrere Simulationen durchgeführt werden, z.B. durch Übertragung eines Steuerbefehls durch eine Kontaktspitze 22 oder 32. Weiterhin kann eine Messwertprüfung eines Bauteils der Leiterplatte 6 durch eine Kontaktspitze 22 oder 32 erfolgen als Antwort auf den übermittelten Steuerbefehl. Eine weitere Kontaktspitze 22 oder 32 kann als Indikationsleitung zur Prüfung der Betriebsbereitschaft der Bauteile der Leiterplatte 6 dienen.

Durch die Kommunikationsschnittstelle 5 kann durch Kontaktieren mit den Kontaktierungsbereichen 11 der Leiterplatte 6 die Ethernetverbindung der Leiterplatte vor dem Kommunikationsmodul für die Ethernetverbindung prüft werden.

Besonders bevorzugt beträgt die Anzahl der Kontaktspitzen 22 oder 32 pro Array-Anordnung 23 oder 33 neun oder zehn.

Die vorbeschriebenen Varianten einer Kommunikationsschnittstelle haben den besonderen Vorteil, dass sie vom Testmodul 4 direkt positioniert werden können und ausgehend von der Testmodul 4 kurze Signal- und Energieversorgungsleitungen zur Kommunikationsschnittstelle 5 aufweisen. Dadurch wird ein Datenverlust durch lange Übertragungswege verhindert und auch eine exakte Signalerzeugung und ein Signalempfang durch die Kommunikationsschnittstelle 5 erreicht.

Die Kontaktierungsbereiche 11 stellen das Gegenstück zur Arrayanordnung 22 oder 32 der Kommunikationsschnittstelle 5 dar. Die Kontaktierungsbereiche 11 können unterschiedliche Formen, z.B. rund oder viereckig, aufweisen. Sie sind eine geschlossene metallische Oberfläche. Eine Mehrzahl an Kontaktierungsbereichen 11, z.B. neun Kontaktierungsbereiche 11, bilden eine Kontaktierungs-Anordnung 12 auf. Die Kontaktierungsbereiche der Kontaktierungs-Anordnung 12 sind in Form eines Musters voneinander beabstandet. Diese Abstände eines Kontaktierungsbereichs 11 sind zu jedem benachbarten Kontaktierungsbereich bevorzugt stets gleich angeordnet. Die Kontaktierungsbereiche sind frei von anderen Bauteilen und/oder Lötstopplack oder anderen Beschichtungen, welche die Datenverbindung stören könnten.

Die Kontaktierungsbereiche 11 der Kontaktierungs-Anordnung 12 der Leiterplatte 9 sind vorzugsweise in einem kreisförmigen Muster, vorzugsweise auf zumindest zwei oder mehr Kreisbahnen angeordnet oder ebenfalls bevorzugt in einem rechteckigen Muster, vorzugsweise quadratisch, auf der Leiterplatte 6 angeordnet.

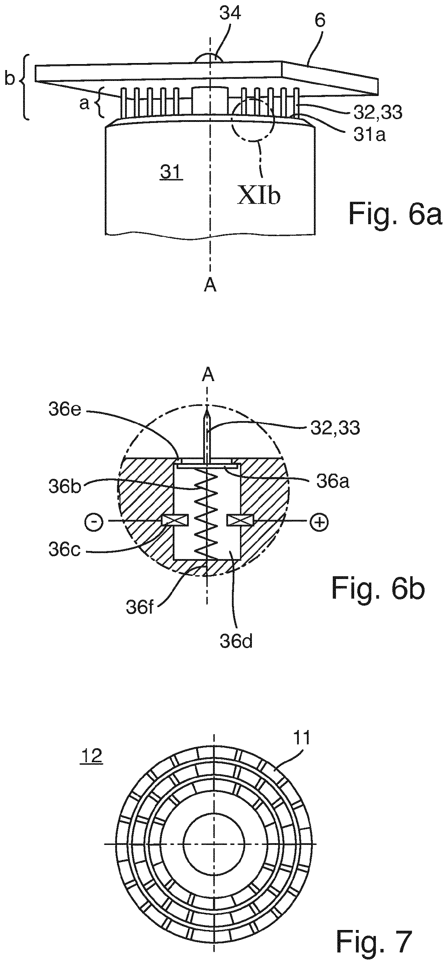

Entsprechende Muster sind in Fig. 6a, 6b und 7 dargestellt.

In Fig. 6b ist im Detail eine Haltevorrichtung 36 einer Kontaktspitze gezeigt. Dadurch ist es möglich Kontaktspitzen aus dem Gehäuse der Kommunikationsschnittstelle aus- und einzufahren. Die in Fig. 6b dargestellte Haltevorrichtung ist dabei nur eine von mehreren Varianten eine Kontaktspitze in einer Einfahrposition im Gehäuse zu halten. Dabei umfasst die Kontaktspitze 32 eine tellerförmige Ausformung 36a. Diese wird ist in einem Kanal 36d beweglich gelagert. Eine Feder 36b drückt gegen die Ausformung 36 a deren Bewegung durch einen Anschlag 36e, welcher in den Kanal hineinragt begrenzt wird. Zum Halten in Einfahrposition ist ein Elektromagnet 36c vorgesehen, welcher den Teller der Kontaktspitze bei Aktivierung des Elektromagneten anzieht. Sofern der Elektromagnet 36c nicht aktiviert wird ist die Kontaktspitze ausschließlich federgelagert. Von der Kontaktspitze geht ein Kabel 36f ab, welches zur Signal- und/oder Energieübertragung dient. Die Haltevorrichtung ist nicht auf Fig. 6a begrenzt sondern kann auch für alle anderen Varianten von vorbeschriebenen Kommunikationsschnittstellen verwendet werden.

Die Kontaktierungsbereiche 11 sind bevorzugt vergoldet oder verzinnt.

Eine entsprechende Kontaktierungs-Anordnung 12 ist vorzugsweise in der Nähe des Kommunikationsmoduls 9 der Leiterplatte 6 auf dem Kommunikationspfad angeordnet, so dass die Kommunikation der einzelnen Bauteile der Leiterplatten und ein Aufspielen von Daten z.B. auf den Datenspeicher der Leiterplatte unter Umgehung des Kommunikationsmoduls 9, also z.B. der Ethernet-Buchse, erfolgen kann.

Eine zu prüfende Leiterplatte 6 mit einem Kommunikationsmodul, welches als Ethernet-Schnittstelle ausgebildet ist kann bei einer Prüfung auf nicht-erfindungsgemäße Weise durch ein beliebiges Testsystem über eine Standard-Ethernet-Buchse mit einer Kommunikationsschnittstelle des Testsystems kontaktiert werden.

Im Rahmen der vorliegenden Erfindung wird jedoch vorgeschlagen, dass eine solche Prüfung automatisiert erfolgt, wobei die Steckverbindung über eine Ethernet-Standardbuchse für diesen Zweck sich als aufwendig erwiesen hat. Eine automatisierte Prüfung einer solchen Ethernet-Schnittstelle wird durch etablierte Firmen, welche automatisierte Testsysteme, z.B. zur Prüfung von Lötkontakten, entwickeln bislang nicht angeboten.

Die Kommunikationsschnittstelle 5 kann bevorzugt eines oder mehrere Bauteile aufweisen, welche den Bauteilen des Kommunikationsmoduls 9 der Leiterplatte 6 nachgebildet sind. Dieses Bauteil ist in Fig. 4 und 5 in dem Gehäuseabschnitt 21 oder 31 angeordnet und kann beispielsweise als Transformermodul 45, auch Umwandler genannt, ausgebildet sein. Ein solches Transformermodul kann vorzugsweise ein sogenannter Ethernet Magnetic Transformer sein, Ein entsprechendes Transformermodul ist zumeist auch in einem Ethernet-Stecker integriert, welcher jedoch durch Kontaktierung des der Kommunikationsschnittstelle 5 mit Kontaktbereichen 11 einer Kontaktierungsanordnung 12 auf der Leiterplatte 6 umgangen werden kann.

Somit kann das Kommunikationsmodul mit den Bauteilen ohne großen Signalverlust vor und nach der Transformation aufgrund langer Datenleitungen über die Arrayanordnung 23, 33 mit der Leiterplatte 6 verbunden werden und Daten austauschen.

Durch die funktionsgleiche Nachbildung der Bauteile des Kommunikationsmoduls 9 der Leiterplatte durch die Bauteile der Kommunikationsschnittstelle 5 des Testmoduls 4 kann eine sichere Kommunikation mit der Prozessoreinheit, dem Datenspeicher und weiteren Bauteilen auf der zu prüfenden Leiterplatte 6 gewährleistet werden, ohne dass es darauf ankommt ob die überbrückte Ethernet-Buchse der Leiterplatte 6 kein Transformermodul, ein Transformermodul oder mehrere Transformermodule in Serie oder parallel zueinander verschaltet aufweist.

Nach dem Auslesen des Typs der Ethernet-Buchse auf der Leiterplatte durch das Testsystem z.B. anhand eines Barcodes auf der Leiterplatte kann das Testsystem eine entsprechende Bauteileschaltung auswählen, welche der Verschaltung des Ethernet-Buchse entspricht, so dass ein identischer Datenaustausch zwischen dem Testsystem 1 und der Leiterplatte 6 trotz Überbrückung ermöglicht wird, so als ob das Testsystem über die Ethernet-Buchse der Leiterplatte 6 mit dieser verbunden ist.

So kann beispielsweise ein Datenaustausch bei einer typischen Datenübertragungsrate von 10 bis 100 Mbit/s erfolgen

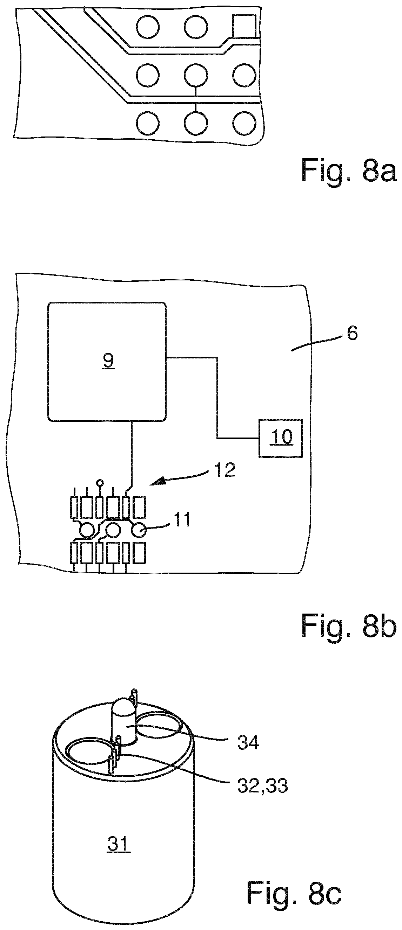

In Fig. 5 und Fig. 8 ist eine Variante einer Array-Anordnung 33 mit dem Zapfen 34 angeordnet, In diese Variante ist der Zapfen als Zentrierzapfen ausgebildet und voneinander beabstandet entlang einer radial zu diesem Zentrierzapfen verlaufenden Linie sind die Kontaktspitzen 32 angeordnet.

Die Kontaktspitzen 32 können ausfahrbar sein und beispielsweise anhand eines Feststellmechanismus bei Bedarf ausgefahren werden. So können je nach Bauteiletyp der Leiterplatte die nicht-benötigten Kontaktspitzen 32 eingefahren werden.

Der Bauteiletyp kann anhand eines auf der Leiterplatte befindlichen Barcodes identifiziert werden, welcher mittels einer auf dem Testmodul 4 befindlichen Kamera 13 identifiziert werden kann. Je nach Vorgabe des Barcodes können sodann entsprechend die Kommunikationsschnittstelle 5 und die dazugehörigen Bauteile, sowie weitere Bauteile des Testmoduls 4 bedient und insbesondere in Bereitschaft versetzt werden.

Durch die einfahrbaren Kontaktspitzen wird weniger Platz auf der zu prüfenden Leiterplatte für Kontaktbereiche 11 benötigt, so dass das Material der Leiterplatte eingespart werden kann und eine optimierte Bauteilanordnung auf der Leiterplatte gelingt.

Die Zentrierung durch den Zentrierzapfen kann insbesondere mit einer Anordnung von Kontaktbereichen 11 auf einer Leiterplatte 6 zusammenwirken, wie sie in Fig. 8 dargestellt ist.

Weiterhin ist es dabei von Vorteil, wenn die Array-Anordnung, also die Anordnung der stiftartigen metallischen Kontaktspitzen 22, 32 drehbar um eine durch den Zentrierzapfen definierte Achse angeordnet ist. So können die stiftartigen Kontaktspitzen besser die Kontaktbereiche 11 anfahren und mit diesen kontaktieren, so kann vorteilhaft die Anzahl an Kontaktbereichen 11 reduziert werden. Die Drehbarkeit der Array-Anordnung ist auch bei rechteckigen Array-Anordnungen der Kontaktspitzen, wie z.B. in Fig. 4, von Vorteil.

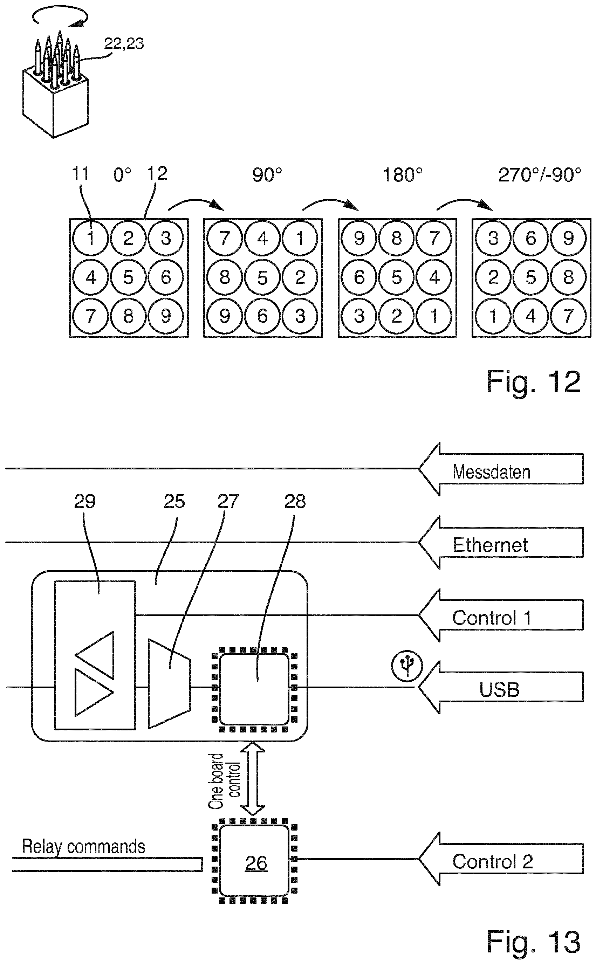

Die Rotierbarkeit der Array-Anordnung 23, 33 wie in Fig 12 und Fig 8 dargestellt ist zudem von Vorteil, da auf diese Weise Leiterplatten 6 mit unterschiedlicher Orientierung, also eine Zuführung in Längs- oder Querrichtung der Leiterplatte, zugeführt und im Testsystem 1 prüft werden können, ohne dass die Leiterplatte durch Rotation in Position gebracht werden muss. Vielmehr kann durch Rotation der Array-Anordnung 23, 33 deren Positionsspitzen 22, 32 nach der Orientierung der Leiterplatte ausgerichtet werden. Ein Verdrehen der Leiterplatte oder ein Zuführen in das Testsystem aus einer nicht-optimalen Richtung hat damit keine Folgen für den Test und das Übertragen von Daten.

Die Rotation der Arrayanordnung, z.B. durch drehbare Lagerung der Arrayanordnung, kann somit sowohl für eine rechteckige Arrayanordnung der Kontaktspitzen als auch für eine lineare Anordnung der Kontaktspitzen vorteilhaft im Rahmen der vorliegenden Erfindung realisiert werden.

Durch Hinterlegung verschiedener Datensätze kann die Testmodul 4 über unterschiedliche Kommunikationsprotokolle mit der zu prüfenden Leiterplatte 6 und den darauf befindlichen Kommunikationsmodule 9 und Datenspeicher 10 kommunizieren so wie in Fig. 13 dargestellt. So kann je nach Kommunikationsart ein individuelles Einspeisen von Kommunikationsprotokollen erfolgen und ggf. zwischen den Kommunikationsarten umgeschaltet werden. Hierfür werden keine weiteren Systeme ermöglicht sondern die Datenübertragung kann während der oberflächlichen Prüfung der Lötstellen und Elektronikbauteile erfolgen.

Dadurch können durch das Testsystem je nach Bedarf verschiedene Kommunikationsprotokolle auf zu prüfende Leiterplatte 6 angewendet werden und/oder die Leiterplatte 6 auf das Vorhandensein dieser Kommunikationsprotokolle prüft werden. Derartige Kommunikationsprotokolle sind z.B. I2C, SPI, USB, Ethernet, Profibus und/oder UART.

Die Pegel der Treiber sind dabei vorzugsweise über eine auf dem Datenspeicher oder einem Logikbaustein des Testmoduls 4 hinterlegte Software oder direkt über das Prüfsystem 1 einstellbar. Somit kann das Testmodul 4 über die Kommunikationsschnittstelle 5 nicht nur mit verschiedenen Kommunikationsprotokollen kommunizieren sondern kann auch den Spannungspegel der Kommunikationssignale auf das Niveau der zu prüfenden Leiterplatte 6 anpassen.

Weiterhin auf dem Datenspeicher oder dem Logikbaustein des Testmoduls 4 ist ein Selbstdiagnoseprogramm hinterlegt, mit welchem eine Diagnose des Testmoduls 4 und der Kommunikationsschnittstelle 5 erfolgen kann und welches von einem Prozessor oder einen Logikbaustein des Testmoduls 4 ausgeführt werden kann.

Im Rahmen der vorliegenden Erfindung wird die Kommunikationsschnittstelle 5 als ein erstes Bauteil zur Funktionsprüfung bezeichnet, mit welcher durch Senden und Empfangen von Kommunikationsdaten an die Leiterplatte 6, die korrekte Datenübertragung der Leiterplatte 6, insbesondere einer der Leiterplatte 6 zugeordneten Prozessoreinheit, welche einen Datenspeicher verwaltet, durch das Testsystem 1 prüft wird. Weitere Bauteile, welche bevorzugt im Rahmen der vorliegenden Erfindung eingesetzt werden können, werden nachfolgend beschrieben.

Die Testmodul 4 weist zumindest eines oder mehrere zweite Bauteile im Rahmen der vorliegenden Erfindung auf, welches als ein Auflageelement 18 zur Beabstandung zwischen der Leiterplatte 6 und dem Testmodul 4 und ggf. zur Stützung der Leiterplatte 6 gegen Durchbiegen dient.

Ein drittes Bauteil, welches auf dem Testmodul 4 angeordnet sein kann, ist eine Kamera 13zur Bilderfassung im sichtbaren Spektralbereich. Diese Kamera 19 kann verschiedene Funktionen erfüllen.

Sie kann zur Positionsbestimmung der zu prüfenden Leiterplatte 6 dienen.

Sie kann alternativ oder zusätzlich auch die zu prüfende Leiterplatte 6 auf Anwesenheit von Bauteilen untersuchen, mit welchen die Leiterplatte bestückt sein sollte.

Die Kamera 13 kann zudem alternativ oder zusätzlich einen Barcode oder eine Seriennummer auf der Leiterplatte 6 erfassen und die Leiterplatte gemäß diesem Barcode bestimmte Datensätze und Steuerprogramme von einem Datenspeicher abrufen und initiieren. Dies kann unter anderem spezielle Vorgaben zur Untersuchung der Leiterplatte 6, respektive der darauf angeordneten Bauteile, umfassen oder den Umfang der Daten, welche an den Datenspeicher der Leiterplatte 6 unter Zuhilfenahme der Kommunikationsschnittstelle übermittelt werden sollen.

Die Kamera 13 kann zudem eine Prüfung von Lötstellen auf Anwesenheit vornehmen.

Weitere Funktionen, beispielsweise weitere Diagnosefunktionen, können noch zusätzlich durch die Kamera ausgeführt werden.

Ein viertes Bauteil des Testmoduls 4 kann beispielsweise eine metallische stiftförmige Prüfspitze 20 z.B. zur Prüfung der unterseitig angeordneten Lötkontakte durch Widerstandsmessung umfassen, welcher jedoch anders als die Prüfspitzen 2 welche von oberhalb der Leiterplatte 6 herangeführt werden, starr mit dem Testmodul 4 oder nur in eine Richtung beweglich, insbesondere ausfahrbar, auf dem Testmodul 4 angeordnet sein kann. Dadurch verringert sich der mechanische Aufwand dieses metallischen Prüfspitze 20.

Alternativ oder zusätzlich zu mechanischen Funktionen oder Diagnosefunktionen durch das vorgenannte Bauteil oder die vorgenannten Bauteile kann auch ausschließlich ein Aufspielen von Daten z.B. von Kommunikationsprotokollen durch die Kommunikationsschnittstelle 5 erfolgen. Durch das Aufspielen der Daten auf den Datenspeicher 10 der zu prüfenden Leiterplatte 6 zeitgleich während des Prüfens der Lötverbindungen z.B. durch die Prüfspitzen 2 wird eine Zeitersparnis erzielt während die Qualitätskontrolle erfolgt.

Das Aufspielen der Daten kann beispielsweise als eine Art Basis- bzw. Grundprogrammierung erfolgen. Die zu prüfende Leiterplatte 6 kann insbesondere in einem Messgerät der Automatisierungstechnik eingesetzt werden. An den Datenspeicher 10 kann in Abhängigkeit von dem jeweiligen Messgerät, dem Einsatzgebiet des Messgerätes und der Produktionsstrecke bei der Herstellung des Messgerätes Daten übertragen werden. Die Datenübertragung kann spezifisch von der Bestückung der Leiterplatte erfolgen, so dass Daten zur Steuerung, Prüfung und/oder Identifizierung der einzelnen Bauteile oder Baugruppen der Leiterplatte 6 vom Datenspeicher des Testmoduls 4 über die Kommunikationsschnittstelle 5 und das Kommunikationsmodul 9 auf den Datenspeicher 10 der Leiterplatte überspielt werden können.

Alternativ oder zusätzlich zu den vorgenannten Bauteilen kann das Testmodul 4 auch eines oder mehrere Werkzeugbauteile 50, beispielsweise ein Lötelement 51 zur Ausbildung eines Lotes oder eine Zange 52, umfassen. Weitere Werkzeugbauteile z.B. Schraubenzieher und dergleichen können ebenfalls vorgesehen sein. Durch die Ansteuerung der Werkzeuge kann eine einfache Reparatur der zu prüfenden Leiterplatte 6 in zeitlich enger Abfolge zur Detektion eines Defekts durch die oberen Prüfspitzen 2 erfolgen oder die Entfernung von Bestückungshilfen erfolgen.

Zusätzlich kann das Testmodul 4 auch eine Strom- und/oder Spannungsquelle zur Spannungsversorgung der Werkzeugbauteile oder der Bauteile zur Funktionsprüfung aufweisen.

Das Testsystem 1 verfügt über den Datenspeicher 35 mit einem darauf abgelegten entsprechenden Testprogramm Dieses Testprogramm steuert den Einsatz des Auflagenelements 18, der Kontaktspitzen 22, der Prüfspitze 20, und/oder ggf. weiterer Werkzeuge 50, 51, 52 und deren Positionierung. Dadurch können unterschiedliche zu prüfende Leiterplatten 6 mit unterschiedlichen Abständen der Bauteile prüft und mit Daten versorgt werden.

Zusätzlich zu den oberseitig durch die Prüfspitzen 2 durchgeführten Lötstellentests erfolgt in der erfindungsgemäßen Variante der vorliegenden Erfindung ein Funktionaltest einzelner Bauteile durch das Testmodul 4.

Die vorgenannten Bauteile der Prüfplatine 4 können einzeln oder besonders bevorzugt gemeinsam auf dem Testmodul 4 angeordnet sein. Letzteres ist von Vorteil, da so ein festgelegter Abstand eingehalten wird.

Durch die Verfahrbarkeit des Testmoduls 4 unterhalb der Leiterplatte 6 in x-, y- und z-Richtung kann zeitgleich zur Qualitätskontrolle der Verbindungen der elektronischen Bauteile mit den Leitungen der Leiterplatte auch eine Funktionsprüfung der jeweiligen Bauteile der zu prüfenden Leiterplatte erfolgen, dies führt zu einer Zeitersparnis und zu einer räumlichen Ersparnis eines zusätzlichen Testsystems.

Ein weiterer Aspekt der vorliegenden Erfindung ist die Spannungs- und/oder Stromversorgung des Testmoduls 4 und der damit verbundenen Bauteile, also die Kommunikationsschnittstelle 5, sowie der zu prüfenden Leiterplatte 6, aber auch weitere Bauteile, z.B. Werkzeugelemente wie Zangen oder Lötelemente oder eine oder mehrere Kameras. Bei bislang bekannten Testsystemen erfolgt die Spannungsversorgung durch eine Strom- und/oder Spannungsquelle außerhalb des Testsystems, also räumlich entfernt von dem Prüfling bzw. der zu prüfenden Leiterplatte 6.

Gemäß dem Konzept der vorliegenden Erfindung ist die Strom- und/oder Spannungsquelle 14 Teil des Testsystems 1 und insbesondere Bestandteil des Testmoduls 4. Dadurch wird ein Spannungsabfall bedingt durch lange Leitungen 17 verhindert. Die Strom- und/oder Spannungsquelle kann durch eine Steuereinheit 15 nach einem Programm oder durch manuelle Eingabe von der Steuereinheit 15 gesteuert werden.

Das Testsystem 1 selber wird durch ein Gehäuse 16 begrenzt. Während das Testmodul 4, sowie die Kommunikationsschnittstelle 5 und die Strom- und/oder Spannungsquelle 14 beweglich im Gehäuse angeordnet ist, so ist die Steuereinheit 15 vorzugsweise starr im oder am Gehäuse 16 des Testsystems 1 oder außerhalb dieses Gehäuses 16 angeordnet.

In einer besonderen Ausführungsvariante der Erfindung sind die Kontaktspitzen 22, 32 direkt mit der Strom- und/oder Spannungsquelle 14 über eine Stromversorgungsleitung verbunden. Die Strom- und/oder Spannungsquelle 14 kann von außen, also außerhalb des Gehäuses 16 des Testsystems 1, mit Energie versorgt werden und ebenfalls von außen mit Steuerbefehlen auf einen Spannungsabgabewert eingestellt werden.

Durch die Steuereinheit 15 kann sowohl die dem Testmodul 4 und insbesondere der Kommunikationsschnittstelle 5 zugeführte Spannung oder die dem Testmodul 4 und insbesondere der Kommunikationsschnittstelle 5 zugeführte Stromstärke eingestellt werden oder sowohl die zugeführte Stromstärke als auch die zugeführte Spannung eingestellt werden. Somit können insbesondere die Kontaktspitzen 22, 32 mit einem Strom mit einer vorbestimmten Spannung und/oder einer vorbestimmten Stromstärke betrieben werden.

Als Strom- und/oder Spannungsquelle 14 wird im Rahmen der vorliegenden Erfindung ein Bauteil bezeichnet, welches aus einer größeren Spannung oder einer größeren Stromstärke unabhängig von der Größe der zugeführten Spannung oder Stromstärke einen diskreten kleineren Spannungs- und/oder Stromstärke-Wert generiert.

Zur Prüfung, welcher Spannungswert an den Kontaktspitzen 22 oder 32 ankommt, kann die Strom- und/oder Spannungsquelle 14 vorzugsweise über eine Rückleseleitung, eine sogenannte Sense-Leitung, mit den Kontaktspitzen verbunden sein. In der vorliegenden Strom- und/oder Spannungsquelle 15 wird die Ausgangsspannung oder ein Teil davon mit einer Referenzspannung verglichen und so ausgeregelt, dass auch bei schwankender Last die Ausgangsspannung auf der zu prüfenden Leiterplatte 6 konstant bleibt. Dieser Zustand liegt allerdings meist nur im idealen Fall vor. Daher wird die mit der Referenzspannung zu vergleichende Spannung in der Nähe der Last, also bei den Kontaktspitzen 22 oder 32 also hinter den Zuleitungen mit dem schwankenden Spannungsabfall mittels der Rückleseleitung ermittelt. Der Spannungsabfall auf den Zuleitungen wird dadurch mit ausgeregelt und die Spannung an der Last, also den Kontaktspitzen der Kommunikationsschnittstelle 5 bleibt auch im Realfall konstant. Die vorgenannte Leitung kann durch Parallelschaltung mit dem Spannungseingang der jeweiligen Prüfspitze erzeugt werden, so dass die Strom- und/oder Spannungsquelle 14 den Spannungsabfall des Leitungswiderstandes ausgleicht. Die von der Strom- und/oder Spannungsquelle 14 erzeugte Spannung kann folglich nach Abgleich mit den rückgelesenen Werten angepasst werden. Damit kann der Spannungsabfall durch den Leitungsweg zwischen den Kontaktspitzen 22, 32 und der Strom- und/oder Spannungsquelle 14 ausgeglichen werden und ggf. auch Spannungsschwankungen ausgeglichen werden.

Insgesamt kann die Spannungsversorgung durch die Strom- und/oder Spannungsquelle durch ein Programm, welches vorzugsweise auf dem Datenspeicher der Testmodul 4 hinterlegt ist, gesteuert werden. Eine bevorzugte Art einer programmierbaren Spannungsquelle ist auch als LDO (Low-Drop-Out Spannungsregler) bekannt und kann im Rahmen der vorliegenden Erfindung als bevorzugte Form einer Strom- und/oder Spannungsquelle 14 eingesetzt werden.

Die Strom- und/oder Spannungsquelle 14 ist so konzipiert, dass sie extrem schnell auf Laständerungen auf der zu Prüfenden Leiterplatte reagieren und ausgleichen kann, vorzugsweise im Bereich von einigen Nanosekunden. Dies wird bevorzugt benötigt, wenn es sich bei der zu Prüfenden Leiterplatte 6 um eine Bauteil mit schnellen Mikroprozessoren mit schneller Kommunikation und Speicherbausteinen handelt das diese dynamische Laständerungen aufweisen. Diese Funktion wird vorzugsweise durch Bausteine mit schnellen Regeleigenschaften realisiert und /oder mit Kondensatoren welche sehr kurze Energiespitzen überbrücken können.

Die Stromstärkewerte können in einer weiteren bevorzugten Variante der Erfindung ebenfalls ausgelesen und durch Abgleich mit einem hinterlegten Datensatz begrenzt werden. Dieser Datensatz kann ebenfalls bevorzugt auf dem Datenspeicher der Testmodul 4 und/oder der Steuereinheit 15 hinterlegt sein.

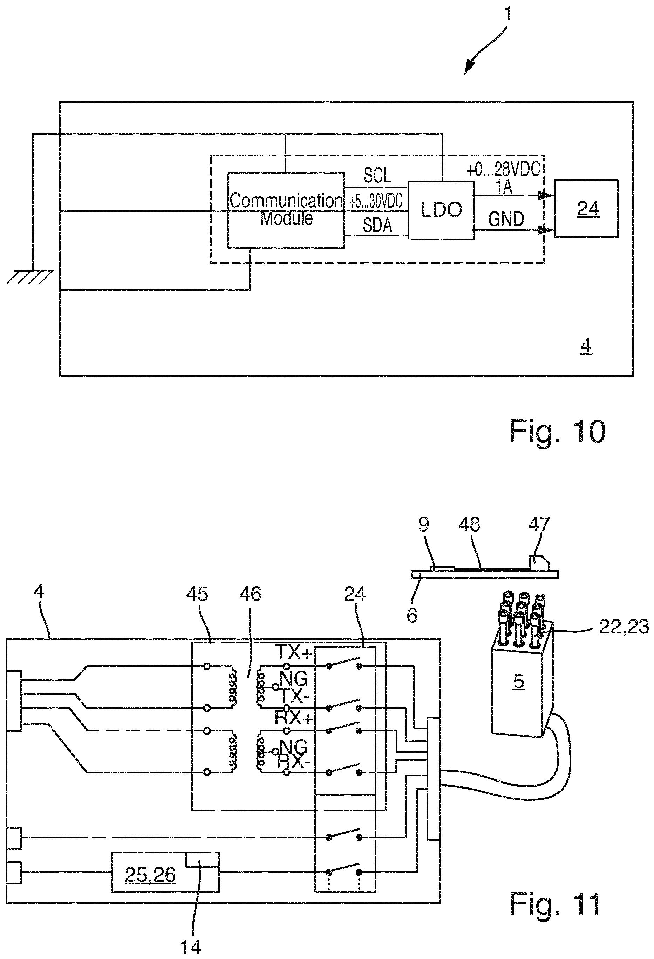

Ein Schaltbild für eine bevorzugte eingesetzte Strom- und/oder Spannungsquelle 14 ist in dem Schaltbild der Fig. 10 dargestellt. Es Zeigt:

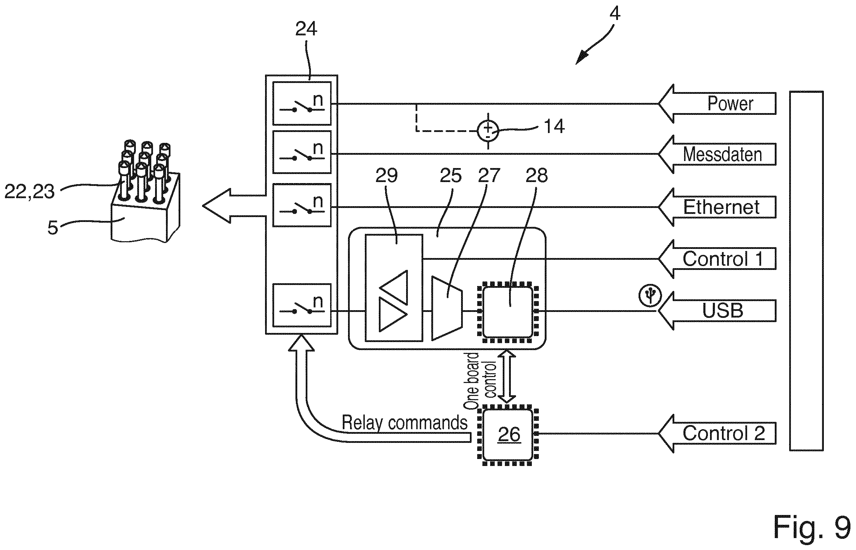

Fig. 9 zeigt die wesentlichen Bestandteile des Kommunikationsmoduls 4. Der Kern bildet die Kommunikationseinheit 25. Sie stellt die verschiedenen Kommunikationsprotokolle dar und /oder wandelt ein vom Testsystem kommendes Protokoll z.B. USB ein anderes Protokoll um. Ein Multiplexer 27 (MUX), der dem Kommunikationschip 28 nachgeschaltet ist, kann die einzelnen Kommunikationssignale auf beliebige Kontaktspitzen 2, 32 der Kommunikationsschnittstelle 5 schalten. Das wiederum bringt Flexibilität bei der Gestaltung der Kontaktpunkte 7 bzw. der Arrayanordnung 23 auf der zu prüfenden Leiterplatte 6.Dem Multiplexer 27 (MUX) kann ein Treiber/Sensor 29 nachgeschaltet sein, der die Signalpegel der Kommunikationssignale anpassen kann. Somit wird die Flexibilität der Kommunikationseinheit 25 erhöht, weil sie sich auf verschiedene Signalpegel und somit auf verschiedene Spannungstechnologien der zu prüfenden Leiterplatte 6 anpassen kann. Weiterhin kann der Treiber/Sensor 29 auch einen Sensor enthalten, der den Strom über die Kommunikationsleitungen misst und bei Abweichungen z.B. eine Fehlermeldung auslöst oder eine Abschaltung vornimmt. Die Steuerung des Kommunikationschip 28, des Multiplexer 27, des Treiber/Sensor 29 und der nachgeschalteten Relaismatrix 24 wird durch ein Logikbaustein 26 dargestellt der wiederum mit dem Testsystem in Verbindung steht. Der Logikbaustein 26 kann durch ein FPGA, ein Mikrocomputer oder ein anderer Chip mit Logikfunktionen realisiert sein. Eine zusätzliche Relaismatrix 24 erweitert die Flexibilität des Testmoduls 4 in dem sie die Möglichkeit bietet mehrere Signalquellen, Spannungsversorgungen, Kommunikationsschnittstellen, und Messdaten sowie die Schnittstellensignale aus der Kommunikationseinheit 25 auf jede beliebige Kontaktspitze 2, 32 der Kommunikationsschnittstelle 5 zu schalten. Das trifft auch für die Strom/ Spannungsquelle 14 des Testmoduls 4 zu aber auch für Versorgungseinheiten des Testsystems 1 wie mit dem Testmodul 4 verbunden sind. Dabei ist auch eine gemischte oder kombinatorische Verschaltung vorstellbar. Die Relaismatrix 24 kann ebenfalls aus der Steuereinheit 26 angesteuert werden.

Der in Fig. 10 dargestellte LDO ist ein sogenannter Low Drop Out Spannungsregler. Das Communication Module ist ein Kommunikationsmodul welches den LDO steuert und die Verbindung zum Testsystem 1 darstellt. Das LDO kann auf dem Testmodul 4 oder dem Kommunikationsinterface 5 lokalisiert sein. Die Abbildung der Fig. 10 zeigt eine Lokalisierung auf dem Testmodul 4.

Das Transformermodul 45 ist vorzugsweise Bestandteil des Testmoduls 4 und kann über die Kommunikationsschnittstelle 5 mit einer zu prüfenden Leiterplatte 6 verbunden werden. Die zu prüfende Leiterplatte enthält ein Kommunikationsmodul 9 das vorzugsweise Ethernet oder Profinet Kommunikation unterstützt. Magnetics 46, also Übertrager oder Transformer, des Transformermoduls 45 sind derart dimensioniert, dass es eine galvanische Trennung zum Kommunikationsmodul 9 realisiert und eine elektrische Anpassung im Sinne einer Ethernetverbindung dargestellt werden kann. Zusätzlich sind die Magnetics 46 des Transformermoduls 45 so berechnet, dass eine Ethernet/Profinet Kommunikation mit 100Mbit/s möglich ist, unabhängig davon ob mit dem Kommunikationsmodul 9 über eine elektrische Verbindung 48 eine sogenannte Ethernet Buchse montiert ist oder auch nicht. Es ist ebenfalls unerheblich ob eine auf der zu prüfenden Leiterplatte 6 montierte Ethernet Buchse 47 bauartbedingt Magnetics enthält oder nicht.

Zusätzlich zu den vorbeschriebenen Bauelementen kann die Testmodul 4 auch ein Thermographiesystem, vorzugsweise in Form einer Infrarot-Kamera 130oder einen Temperatursensor, vorzugsweise einen berührungslos messender Temperatursensor, aufweisen. Die Variante des Temperatursensors ist allerdings weniger bevorzugt, aufgrund des geringeren Erfassungsbereichs der Temperaturmessung. Die Infrarot-Kamera hingegen erlaubt eine Temperaturmessung einzelner Bauelemente einer zu prüfenden Leiterplatte 6 und deren Verbindung mit der Leiterplatte 6. Die Temperaturmessung der IR-Kamera kann durch die freie Positionierung der Testmodul 4 mit der IR-Kamera 30 entlang der Oberfläche der zu prüfenden Leiterplatte 6 an bestimmten bevorzugten Stellen erfolgen. Die Temperaturmessung kann bevorzugt berührungslos erfolgen. Alternativ oder zusätzlich zur Temperaturmessung durch die Infrarot-Kamera kann auch eine Prüfspitze mit einem Temperatursensor versehen durch Kontaktierung mit der Leiterplatte eine Temperaturmessung durchführen. Diese Variante benötigt allerdings einen höheren konstruktiven und steuerungsmechanischen Aufwand verbunden mit einer zeitintensiveren Messung im Vergleich zur IR-Kamera.

Fig. 3 zeigt eine Produktionsstrecke 1 zur Herstellung und Prüfung von erfindungsgemäßen Leiterplatten 6, welche vorzugsweise in Messgeräten der Automatisierungstechnik, z.B. in Messaufnehmern oder in Messwandlern, eingesetzt werden können.

Die Produktionsstrecke 1 weist eine Station 101 zur Bereitstellung eines Leiterplatten-Grundkörpers, auch Nutzen genannt, auf. Der Leiterplatten-Grundkörper kann bereits Leiterbahnen aufweisen.

Die Produktionsstrecke weist eine Transportvorrichtung 102, beispielsweise ein Förderband, auf, mit welcher der Leiterplatten-Grundkörper in Transportrichtung R von Station zu Station weitertransportiert wird.

Ausgehend von der Station 101 in welcher die Bereitstellung des Leiterplatten-Grundkörpers erfolgt, wird dieser weitertransportiert zu einer Station 103 zur Bestückung des Leiterplatten-Grundkörpers mit Elektronik-Bauteilen, wobei zumindest eine dieser Bauteile ein intelligentes Bauteil ist, welches beispielsweise als Kommunikationsmodul 9 zur Kommunikation mit anderen von der Leiterplatte abgesetzten Elektronik-Geräten ausgebildet ist. Ein weiteres intelligentes Bauteil ist eine zentrale Prozessoreinheit, die Teil der zu prüfenden Leiterplatte 6 ist und welche die Daten des Datenspeichers 10 verwaltet. Dabei wird aus dem Leiterplatten-Grundkörper die Leiterplatte 6 ausgebildet. Die Bestückung kann z.B. mit Hilfe vorher auf dem Leiterplattengrundkörper aufgebrachten Bestückungsmasken erfolgen.

Im Anschluss an die Station 103 zur Bestückung wird die Leiterplatte erfolgt ein Transport der Leiterplatte 6 in einen Lötofen 104. In diesem erfolgt eine Verlötung der Elektronik-Bauteile mit dem Leiterplatten-Grundkörper.

Nach dem Durchlauf durch den Lötofen 104 erfolgt eine Endkontrolle der fertiggestellten Leiterplatte 6 durch das Testsystem 105. Dabei erfolgt durch das Testsystem 105 eine gleichzeitige Kontrolle
a) der elektrischen Kontaktierung der Lötstellen zwischen den Bauteilen und der Leiterplatte und
b) eine funktionale Prüfung einer oder mehrerer der intelligenten Bauteilen so z.B. des Kommunikationsmoduls 9.

Die vorgenannte funktionale Prüfung umfasst bevorzugt eine Funktionsprüfung des Kommunikationsmoduls 9, eine Programmierung und/oder eine Prüfung der Programmierung des Datenspeichers 10 der Leiterplatte 6, eine Kontrolle der Datenleitung ausgehend vom Kommunikationsmodul zur zentralen Prozessoreinheit der Leiterplatte 6.

Die komplexe Prüfung von Daten auf dem Datenspeicher, der Prozessoreinheit und des Kommunikationsmoduls kann nicht durch einzelne Prüfspitzen, wie sie von der Oberseite der Leiterplatte herangeführt werden, erfolgen. Hierfür bedarf es der vorbeschriebenen Kommunikationsschnittstelle 5 vorzugsweise mit den vorbeschriebenen Ausgestaltungen der jeweiligen Array-Anordnungen 23 oder 33 aus mehreren Kontaktspitzen 22 oder 32.

## Patentansprüche

1. Testsystem (1) zur Überprüfung von elektrischen Verbindungen, zwischen elektronischen Bauteilen einer zu überprüfenden Leiterplatte (6) und dieser Leiterplatte (6), umfassend:
- ein Gehäuse (1b);
- eine Kommunikationsschnittstelle (5);
- eine Temperaturmesseinrichtung (30) zur Temperaturmessung und/oder zur Ermittlung von Wärmekennwerten von der elektrischen Verbindungen der Leiterplatte und/oder zur Temperaturmessung und/oder zur Ermittlung von Wärmekennwerten von den elektronischen Bauteilen, und
- stiftartige Prüfspitzen, welche oberhalb der zu überprüfenden Leiterplatte (6) beweglich angeordnet sind,
wobei die Prüfspitzen dazu eingerichtet sind, an die zu überprüfende Leiterplatte herangeführt zu werden und an Kontaktpunkten (7), welche auf der zu überprüfenden Leiterplatte (6) angeordnet sind Widerstandswerte zu ermitteln,
**dadurch gekennzeichnet,**
**dass** die Kommunikationsschnittstelle (5) und die Temperaturmesseinrichtung (30) fest mit einem Testmodul (4) verbunden sind, welches beweglich in mindestens zwei Raumrichtungen im Gehäuse (1b) des Testsystems (1) unterhalb der zu prüfenden Leiterplatte (6) angeordnet ist.

2. Testsystem (1) nach Anspruch 1, **dadurch gekennzeichnet, dass** die Temperaturmesseinrichtung beweglich in zumindest zwei Raumrichtungen innerhalb eines Gehäuses (1a) des Testsystems (1) angeordnet ist.

3. Testsystem (1) nach Anspruch 1 oder 2, **dadurch gekennzeichnet, dass** durch die Temperaturmesseinrichtung eine berührungslose Temperatur-Messung erfolgt.

4. Testsystem (1) nach einem der vorhergehenden Ansprüche, **dadurch gekennzeichnet, dass** die Temperaturmessung durch ein Thermographiesystem, insbesondere durch eine Infrarot-Kamera erfolgt.

5. Testsystem (1) nach einem der vorhergehenden Ansprüche, **dadurch gekennzeichnet, dass** das Testsystem (1) eine Kommunikationsschnittstelle (5) mit zumindest drei elektrisch-leitenden Kontaktspitzen (22, 32) aufweist, welche durch Kontaktierung mit einer Kontaktierungsanordnung (12) auf der Leiterplatte (6) mit mehreren Kontaktierungsstellen (11) einen Datenaustausch mit einem Datenspeicher ermöglicht, welcher auf der zu überprüfenden Leiterplatte (6) angeordnet ist, wobei der Datenaustausch nach einem Kommunikationsprotokoll erfolgt.

6. Testsystem (1) nach einem der vorhergehenden Ansprüche, **dadurch gekennzeichnet, dass** das Testmodul (4) einen Datenspeicher (35) aufweist, auf welchem Datensätze hinsichtlich zumindest einer zulässigen Wärmeskalierung einzelner Bauteile und/oder Teilbereiche einer Leiterplatte für einen Vergleich mit den ermittelten Temperatur- und/oder Wärmewerten der Bauteile der Leiterplatte hinterlegt sind.

7. Testsystem (1) nach einem der vorhergehenden Ansprüche, **dadurch gekennzeichnet, dass** das Testmodul (4) eine Sensorvorrichtung, insbesondere eine Kamera oder einen Barcodescanner, zur Erkennung eines Erkennungsmerkmals der Leiterplatte (6), insbesondere eines Barcodes oder Seriennummer oder QR-Code, aufweist wobei das Testsystem anhand des Erkennungsmerkmals einen Datensatz bezüglich eines zulässigen Temperaturprofils für diesen Leiterplattentyp aufruft.

8. Testsystem (1) nach einem der vorhergehenden Ansprüche, **dadurch gekennzeichnet, dass** das Testsystem eine Strom- und/oder Spannungsquelle (14) zur Energieversorgung der Temperaturmesseinrichtung aufweist, wobei die Strom- und/oder Spannungsquelle (14) fest verbunden mit der Temperaturmesseinrichtung ist und beweglich in mindestens zwei Raumrichtungen innerhalb des Gehäuses (1a) des Testsystems (1) angeordnet ist.

9. Testsystem (1) nach einem der vorhergehenden Ansprüche, **dadurch gekennzeichnet, dass** das Testsystem, insbesondere das Testmodul (6), zumindest ein Werkzeugbauteil aufweist zur Reparatur von elektrischen Verbindungen an oder auf der Leiterplatte, wobei das Werkzeugbauteil anhand von mittels der Temperaturmesseinrichtung ermittelten Messwerten gesteuert wird.

## Claims

1. Test system (1) designed to test electrical connections between electronic components of a printed circuit board (6) to be tested and this printed circuit board (6), said system comprising:
- a housing (1b);
- a communication interface (5);
- a temperature measuring unit (30) designed to measure the temperature and/or to determine thermal characteristics of the electrical connections of the printed circuit board and/or to measure the temperature and/or to determine the thermal characteristics of the electronic components, and
- pin-like test probes which are arranged in a mobile manner above the printed circuit board (6) to be tested,
wherein the test probes are designed to be introduced to the printed circuit board to be tested and to determine resistance values at contact points (7) that are arranged on the printed circuit board (6) to be tested, **characterized in that** the communication interface (5) and the temperature measuring unit (30) are permanently connected to a test module (4), which is arranged in a mobile manner in at least two spatial directions in the housing (1b) of the test system (1) below the printed circuit board (6) to be tested.

2. Test system (1) as claimed in Claim 1, **characterized in that** the temperature measuring unit is arranged in a mobile manner in at least two spatial directions inside a housing (1 a) of the test system (1).

3. Test system (1) as claimed in Claim 1 or 2, **characterized in that** the temperature measuring unit performs a non-contact temperature measurement.

4. Test system (1) as claimed in one of the previous claims, **characterized in that** the temperature measurement is performed by a thermographic system, particularly by an infrared camera.

5. Test system (1) as claimed in one of the previous claims, **characterized in that** the test system (1) has a communication interface (5) with at least three electrically conductive contact points (22, 32), which enables data exchange with a data memory unit by being put into contact with a contacting arrangement (12) on the printed circuit board (6) with several contact points (11), wherein said memory unit is arranged on the printed circuit board (6) to be tested, wherein the exchange of data is performed according to a communication protocol.

6. Test system (1) as claimed in one of the previous claims, **characterized in that** the test module (4) has a data memory unit (35) on which data records regarding at least a permitted thermal scaling of individual components and/or partial areas of a printed circuit board are saved for a comparison with the temperature values and/or heat values determined for the components of the printed circuit board.

7. Test system (1) as claimed in one of the previous claims, **characterized in that** the test module (4) comprises a sensor apparatus, particularly a camera or a barcode scanner, for detecting a detection characteristic of the printed circuit board (6), particularly a barcode or a serial number or a QR code, wherein, using the detection characteristic, the test system calls up a dataset with regard to a permitted temperature profile admissible for this type of printed circuit board.

8. Test system (1) as claimed in one of the previous claims, **characterized in that** the test system has a current and/or voltage source (14) for the provision of energy to the temperature measuring unit, wherein the current and/or voltage source (14) is permanently connected to the temperature measuring unit and is arranged in a mobile manner in at least two spatial directions inside the housing (1a) of the test system (1).

9. Test system (1) as claimed in one of the previous claims, **characterized in that** the test system, particularly the test module (6), has at least a tool component for repairing electrical connections at or on the printed circuit board, wherein the tool component is controlled by means of measured values determined by a temperature measuring unit.

## Revendications

1. Système de test (1) destiné au contrôle de connexions électriques entre des composants électroniques d'une carte de circuit imprimé (6) à contrôler et cette carte de circuit imprimé (6), lequel système comprend :
- un boîtier (1b) ;
- une interface de communication (5) ;
- un dispositif de mesure de température (30) destiné à mesurer la température et/ou à déterminer les caractéristiques thermiques des connexions électriques de la carte de circuit imprimé et/ou à mesurer la température et/ou à déterminer les caractéristiques thermiques des composants électroniques, et
- des pointes de test en forme de broche qui sont disposées de manière mobile au-dessus de la carte de circuit imprimé (6) à contrôler,
les pointes de test étant adaptées pour être approchées de la carte de circuit imprimé à contrôler et pour déterminer des valeurs de résistance aux points de contact (7) qui sont disposés sur la carte de circuit imprimé (6) à contrôler,
**caractérisé en ce que**
l'interface de communication (5) et le dispositif de mesure de température (30) sont reliés de manière fixe à un module de test (4), lequel module est disposé de manière mobile dans au moins deux directions spatiales dans le boîtier (1b) du système de test (1) en dessous de la carte de circuit imprimé (6) à contrôler.

2. Système de test (1) selon la revendication 1, **caractérisé en ce que** le dispositif de mesure de température est disposé de manière mobile dans au moins deux directions spatiales à l'intérieur d'un boîtier (1a) du système de test (1).

3. Système de test (1) selon la revendication 1 ou 2, **caractérisé en ce que** le dispositif de mesure de température effectue une mesure de température sans contact.

4. Système de test (1) selon l'une des revendications précédentes, **caractérisé en ce que** la mesure de température est effectuée par un système de thermographie, notamment par une caméra infrarouge.

5. Système de test (1) selon l'une des revendications précédentes, **caractérisé en ce que** le système de test (1) présente une interface de communication (5) avec au moins trois pointes de contact électriquement conductrices (22, 32), laquelle interface, par mise en contact avec un arrangement de mise en contact (12) sur la carte de circuit imprimé (6) avec plusieurs points de mise en contact (11), permet un échange de données avec une mémoire de données, laquelle mémoire est disposée sur la carte de circuit imprimé (6) à contrôler, l'échange de données s'effectuant selon un protocole de communication.

6. Système de test (1) selon l'une des revendications précédentes, **caractérisé en ce que** le module de test (4) présente une mémoire de données (35) dans laquelle sont mémorisés des jeux de données concernant au moins une échelle thermique admissible de composants individuels et/ou de zones partielles d'une carte de circuit imprimé pour une comparaison avec les valeurs de température et/ou de chaleur déterminées des composants de la carte de circuit imprimé.

7. Système de test (1) selon l'une des revendications précédentes, **caractérisé en ce que** le module de test (4) comprend un dispositif de détection, notamment une caméra ou un scanner de codes à barres, lequel dispositif est destiné à la reconnaissance d'une caractéristique de reconnaissance de la carte de circuit imprimé (6), notamment d'un code à barres ou d'un numéro de série ou d'un QR code, le système de test appelant, à l'aide de la caractéristique de reconnaissance, un jeu de données concernant un profil de température admissible pour ce type de carte de circuit imprimé.

8. Système de test (1) selon l'une des revendications précédentes, **caractérisé en ce que** le système de test comporte une source de courant et/ou de tension (14) pour l'alimentation en énergie du dispositif de mesure de température, la source de courant et/ou de tension (14) étant reliée de manière fixe au dispositif de mesure de température et étant disposée de manière mobile dans au moins deux directions spatiales à l'intérieur du boîtier (1a) du système de test (1).

9. Système de test (1) selon l'une des revendications précédentes, **caractérisé en ce que** le système de test, notamment le module de test (6), présente au moins un composant d'outil pour la réparation de connexions électriques sur la carte de circuit imprimé, le composant d'outil étant commandé à l'aide de valeurs de mesure déterminées par un dispositif de mesure de température.
